# EUROPEAN PATENT SPECIFICATION

(11) **EP 2 684 977 B1**
(45) Date of publication and mention of the grant of the patent: **17.06.2015**
(21) Application number: 13175966.4
(22) Date of filing: 10.07.2013
(51) Int. Cl.: C23C 14/16, C23C 14/58, H01M 8/02, H01M 8/12

(54) **A method for the deposition of a film of a manganese/cobalt mixed oxide on a metallic substrate**
Verfahren zur Abscheidung eines Films eines Mangan-/Kobaltmischoxids auf einem metallischen Substrat
Procédé pour le dépôt d'un film d'oxyde mixte de cobalt/manganèse sur un substrat métallique

(30) Priority: 10.07.2012 IT TO20120610
(43) Date of publication of application: 15.01.2014
(73) Proprietor: Edison S.p.A., 20121 Milano (IT)
(72) Inventor: Bindi, Massimiliano, 10042 Nichelino (IT)
(74) Representative: Boggio, Luigi

(56) References cited:
- EP-A1- 1 786 056
- WO-A1-2011/096939
- BALLAND A ET AL: "Investigation of La2O3 and/or (Co,Mn)3O4 deposits on Crofer22APU for the SOFC interconnect application", SURFACE AND COATINGS TECHNOLOGY, vol. 203, no. 20-21, 23 April 2009 (2009-04-23), pages 3291-3296, XP026142649, ELSEVIER, AMSTERDAM [NL] ISSN: 0257-8972, DOI: 10.1016/J.SURFCOAT.2009.04.017 [retrieved on 2009-04-23]
- WEI P ET AL: "Oxidation Behavior and Conductivity of UNS 430 Stainless Steel and Crofer 22 APU with Spinel Coatings", ECS TRANSACTIONS - 10TH INTERNATIONAL SYMPOSIUM ON SOLID OXIDE FUEL CELLS (SOFC-X), NARA [JP], vol. 7, 3 June 2007 (2007-06-03), pages 2135-2143, XP055053526, The Electrochemical Society Inc., Pennington NJ [US] DOI: 10.1149/1.2729328 ISBN: 978-1-56-677556-4

## Description

The present invention relates to a method for the deposition of a film of a manganese/cobalt mixed oxide on a metallic substrate, in particular for the coating of electrical interconnections of stacked solid oxide fuel cells (SOFC). In greater detail, the invention refers to the formation, on said metallic interconnections, of a protective layer acting as a barrier against the diffusion of elements constituting the metallic alloy of the interconnection (typically the diffusion of Cr) inside the components of each SOFC (cathode, electrolyte, anode).

Solid oxide fuel cells are electrochemical devices which produce electrical energy by exploiting an oxidation reaction of a fuel. They are distinguished from other types of fuel cells due to the type of electrolyte, consisting of a solid oxide (typically zirconia doped with yttrium oxide), which is used to convey O²⁻ ions from the cathode to the anode. The electrochemical oxidation of the O²⁻ ions with hydrogen or carbon monoxide therefore takes place on the anode side.

Considering a system which is effective in terms of cost and energy efficiency, the SOFC are stacked in series to form relative stacks, interposing metallic interconnections between the individual cells, in order to obtain physical and electrical contact and to separate combustible and oxidising gas.

However, in an oxidising environment and at the typical operating temperatures of the SOFCs, between 500 and 1000°C, the elements constituting the metallic alloys typically used for production of the interconnections tend to form volatile compounds, which are released outside the interconnection, diffusing inside the components of the cell (cathode and electrolyte). Said diffusion causes a progressive deterioration in performance of the stack in terms of the generation of electrical power.

The most promising materials for production of the interconnections comprise, for example, ferritic stainless steels. These, however, are particularly sensitive to the release of chromium-based volatile compounds, which has the effect of increasing the resistance of the interconnection and, therefore, reducing the electric conductivity and the working life of the fuel cell as a whole.

In order to remedy said drawback, the deposition of a protective layer on the metallic interconnections for SOFCs has been proposed. Said protective layer should have: chromium and oxygen diffusion coefficients as low as possible, in order to obstruct the relative migration; chemical compatibility and stability vis-à-vis the interconnection, the electrodes and the materials used in the stack in general; thermodynamic stability both in a reducing atmosphere and in an oxidising atmosphere, in the entire operating temperature range of the SOFC; low ohmic resistance, in order to maximise the electrical efficiency; and a thermal expansion coefficient as similar as possible to that of the alloy constituting the interconnection in order to avoid phenomena of spallation.

It has been observed that the application of a protective layer comprising a mixed oxide with cubic crystalline structure such as a cobalt and manganese spinel (Mn, Co)₃O₄ constitutes a valid solution to this problem.

Even more particularly, it has been found that the spinel represented by the formula MnₓCo_{y}O_{4-δ}, where x+y=3, is the most promising material for said application. In fact, coating the interconnections with a protective layer based on said material not only results in reduced contact resistance between the cathode of the SOFC and the interconnection, but an effective barrier effect has also been found vis-a-vis the migration of the chromium through the protective layer itself and prevention of surface oxidation of the interconnection. Consequently, the global electrical performance of the system has been advantageously preserved.

BALLAND A ET AL in SURFACE AND COATINGS TECHNOLOGY, vol. 203, no. 20 - 21, 23 April 2009,DOI: 10.1016/ J.SURFCOAT.2009.04.017 reports a method in which a Crofer® 22 APU sheet is coated with metallic cobalt manganese deposited by DC magnetron co-sputtering of a target Co:Mn, 1:1 in an argon atmosphere. (Co,Mn)₃O₄ forms from Co:Mn during the first hours of oxidation at 800 °C in air.

WEI P ET AL in ECS TRANSACTIONS - 10TH INTERNATIONAL SYMPOSIUM ON SOLID OXIDE FUEL CELLS (SOFC-X), NARA [JP], vol. 7, 3 June 2007, DOI: 10.1149/1.2729328 reports a method in which a Crofer® 22 APU coupon is electroplated first with cobalt and then with manganese. Therafter, the coupons are oxidized in air for 1400 h at 750 °C, resulting in the formation of Co-Mn spinel.

The techniques currently available for deposition of the manganese and cobalt oxide layer MnxCoyO4-δ (x+y=3) are not fully satisfactory, however. In particular, they are complex and costly, both in terms of the time required for their implementation and in economic terms.

The need is therefore felt in the sector to provide an alternative method for the deposition of a film of a manganese and cobalt mixed oxide represented by the formula MnxCoYO4-δ which overcomes the drawbacks previously described. In particular, the need is felt to provide a method for the deposition of a film of a said mixed oxide on a metallic substrate of the type used for the production of interconnections for solid oxide fuel cells which is simpler, more economic and effective.

One object of the present invention is to provide a method for the deposition of a film of a mixed oxide of manganese and cobalt represented by the formula MnₓCo_{y}O_{4-δ} able to meet the above-mentioned needs.

Said object is achieved by the present invention, since it is relative to a method according to claim 1.

Further characteristics and advantages of the present invention will be better understood by means of the following description of a preferred embodiment thereof, which is provided by way of nonlimiting example, with reference to the accompanying drawings, in which:

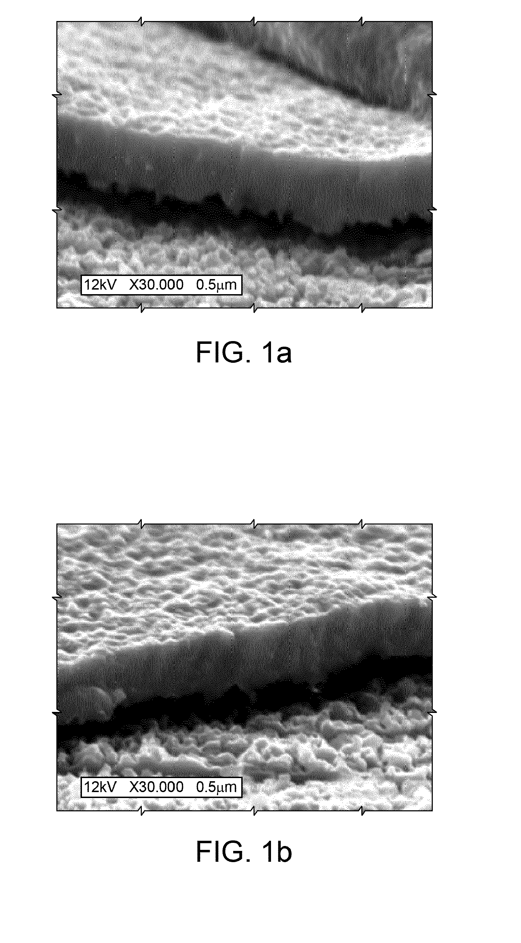

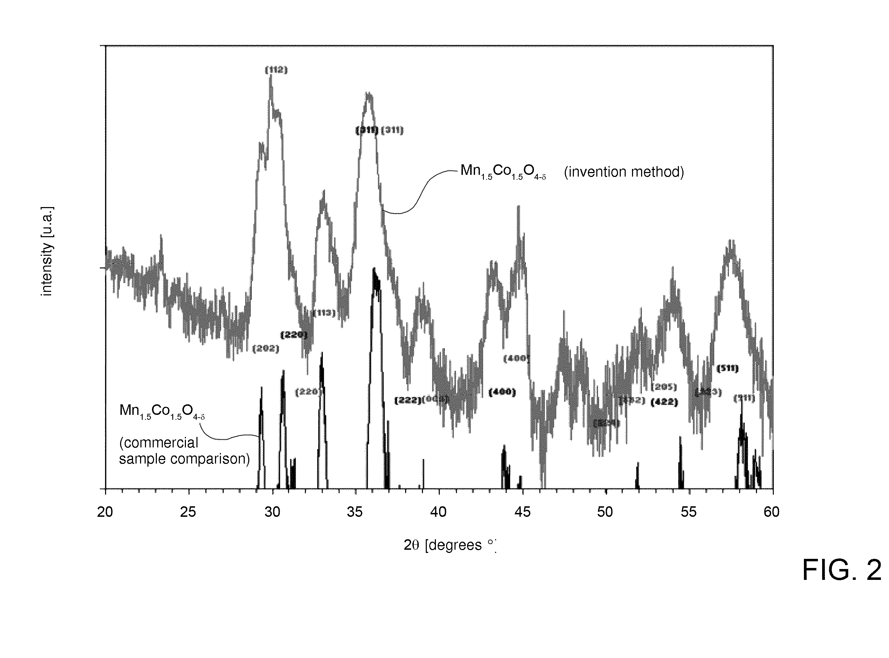

Figures 1a and 1b are SEM micrographs of an interconnection for SOFCs coated with a film of a manganese and cobalt mixed oxide represented by the formula MnₓCo_{y}O_{4-δ} with (x+y) =3 according to the method of the present invention; and Figure 2 is an X-ray diffractogram relative to the coating layer obtained according to the method of the present invention.

The present invention is relative to a method for the formation of a mixed oxide protective film with formula MnₓCo_{yO4-δ}, where x+y=3, on a metallic substrate.

In particular, the substrate is preferably a metallic substrate in iron and chromium-based alloy, if necessary comprising other elements in lesser quantities. Furthermore, the metallic substrate is preferably already formed for the final application. More preferably, the substrate consists of a metallic interconnection of SOFCs.

For example, the substrate is an interconnection of CROFER^{®} 22 APU produced by ThyssenKrupp, a ferritic stainless steel for high temperature applications, which has the tendency to form, up to temperatures in the order of 900°C, a surface layer of chromium and manganese oxide which has a high stability and optimal electrical conductivity.

Advantageously, the method comprises the steps of:
a) depositing on the substrate manganese and cobalt as metal species in a molar ratio x/y corresponding to the above-mentioned formula by thermal co-evaporation; and
b) oxidising the metal species *in situ* to form the desired mixed oxide.

In particular, in step a) of deposition by thermal co-evaporation, the metal species are hot-evaporated, under a high vacuum, and deposited on the substrate in a quantity sufficient to guarantee substantial uniformity of the film in terms of composition and thickness.

Preferably, step a) of deposition by thermal co-evaporation comprises the steps of:
c) introducing the metallic substrate into a chamber in which a high vacuum can be created;
d) reducing the pressure inside the chamber below 10⁻⁴ mbar;
e) heating the substrate to a temperature in the range from 300°C to 600°C;
f) feeding, from respective evaporation sources, metallic manganese and cobalt in a relative proportion corresponding to that of formula MnₓCo_{y}O_{4-δ}, where x+y=3, so as to deposit a layer of manganese and cobalt as metal species on the substrate, obtaining a pre-treated substrate.

In particular, flakes of manganese and pieces of cobalt having purity of at least 99,5% are preferably used as starting materials to be evaporated.

Preferably, the substrate is heated to a temperature in the range from 450 to 550°C, more preferably to a temperature of around 500°C.

Of the various evaporation sources that can be potentially used, boats or crucibles containing the metal species in the solid state are the simplest and most effective. Given their reduced overall dimensions, boats or crucibles can be advantageously arranged in groups, thus favouring the compositional uniformity of the layer that forms on the substrate. The obtaining of an adequate compositional uniformity can also be regulated by modifying the distance between the evaporation sources and the substrate, remembering that an increase in said distance favours uniformity but will result in less efficient exploitation of the material, a part of which is deposited on the walls of the chamber in which the process is carried out.

Obviously when working with boats or crucibles, it is necessary to replenish the contents over time, and this can be easily done by providing vibration conveyors for the transport of new starting material.

In practice, when the substrate has been heated to the required temperature, an appropriate electrical current is passed through the crucibles (by the application of a corresponding electrical voltage), thus causing heating and evaporation of the metal species contained in them. The material of the boats or crucibles must clearly be selected so as to withstand the process operating temperatures. Furthermore, said material must be chemically inert with respect to the manganese and cobalt.

For control of the composition of the material deposited on the substrate, it is possible to provide a feedback control system based on monitoring, for example by means of atomic absorption spectrometry (AAS), of the composition of the vapours. It should be noted that the evaporation speed of the metal species is proportional to the density of the vapour and to the speed of propagation of the atoms in the vapour. However, while the density of the vapour depends substantially on the temperature of the relative evaporation source according to an Arrhenius type law, the mean propagation speed varies with the square root of the temperature inside the chamber. Consequently, the speed of the atoms inside the vapour can be considered roughly constant and the variations in the evaporation speed depend almost exclusively on the density variations of the vapour. It is therefore possible to appropriately calibrate, over time, the evaporation speed of the metal species and, consequently, the composition of the material deposited on the substrate.

Preferably, step f) of feeding/evaporation of the metal species and relative consequent transfer onto the substrate is performed for a sufficient time to obtain the formation, on the substrate to be coated, of a surface layer having a thickness of at least approximately 1 µm.

Preferably, step b) of *in situ* oxidation of the metal species comprises the step of:
g) bringing the temperature of the pre-treated substrate to a temperature in the range from 500°C to 800°C, at the same time introducing into the chamber, at least in the vicinity of the substrate, a flow of substantially pure gaseous oxygen, until reaching in the chamber a partial oxygen pressure in the range from 500 mbar to 1000 mbar, thus obtaining the metallic substrate coated by the protective film.

In practice, once the transfer of metallic Mn and Co onto the substrate has been completed, the vacuum pump is switched off and application of the electrical voltage to the crucibles is interrupted.

While *in situ* oxidation of the metal species is performed - without the need to open the vacuum chamber -the temperature values of the substrate and of the (partial) oxygen pressure in the chamber, once regulated, are maintained substantially constant for a time in the order of approximately 30 minutes.

Preferably, the pre-treated substrate obtained from step a) of the method is brought to a temperature in the range from 650 to 750°C, more preferably to a temperature of around 700°C.

Furthermore, the final oxygen pressure inside the chamber is preferably around 1000 mbar.

From an examination of the characteristics of the method according to the present invention, and with reference to the following examples, the advantages thereof are evident.

In particular, the method of the invention is, as a whole, particularly simple and reliable and allows, above all, coatings to be obtained which are fully suited, for example, to preventing the diffusion of elements constituting the metallic alloy of the interconnection inside an SOFC. The technique of deposition by thermal co-evaporation had not been used, so far, for the production of thin films of manganese and cobalt oxide MnxCoyOH5 (x+y=3), but proved to be surprisingly very suitable for said application.

Furthermore, the equipment necessary for implementation of the method according to the present invention is relatively simpler and cheaper than that required for other vacuum deposition techniques.

Lastly, it is clear that modifications and variations can be made to the method described and illustrated here which do not depart from the protective scope of the attached independent claims.

The invention is further described in the following non- limiting implementation example.

### EXAMPLE 1

A tantalum crucible was filled with 3 grams of manganese flakes (purity 99,8%). In parallel, a tungsten crucible with aluminium oxide protective coating was filled with 4 grams of cobalt (purity 99,9%).

A metallic alloy substrate known commercially as CROFERE 22APU was provided.

The substrate was arranged in a vacuum chamber in which the pressure was brought to approximately 2,0-10-5 hPa ( mbar), below a heating device arranged at a height of approximately 45 cm above the crucibles.

During the first step of deposition and growth, no flow of gas was sent into the chamber from the outside.

For this experiment the two crucibles were electrically supplied, regulating the evaporation so as to obtain, in the layer deposited, the molecular ratio between Mn and Co corresponding to the formula of the mixed oxide Mn1.5Co1.504-5.

The following operating parameters were used for the first of the two steps, that of deposition and growth: (1 Å = 0,1 nm; mbar = hPa)
- substrate temperature: 500°C
- deposition time: 30 min
- actual deposition speed: 5 Å/sec

The following operating parameters were used for the second of the two steps, that of oxygenation:
- substrate temperature: 700°C
- oxygen pressure: 1000 mbar
- annealing time: 30 min

Structural analyses were performed on the sample produced according to the procedures described above, using X-ray diffractometry directly on the thin film deposited.

The analysis was performed also on the powder as is.

Said analyses confirmed (see Figure 2) the presence of the sole phase Mn1.5Co1.504-δ with total cubic crystallographic structure.

In particular, Figure 2 shows the diffractogram obtained on the layer deposited according to the method of the invention and, for comparison, a second diffractogram obtained on a commercial sample of Mn_{1.5}Co_{1.5}O_{4-δ}. Furthermore, the Miller indexes characteristic of the peaks of MnCo₂O₄ (in grey) and Mn₂CoO₄ (black) were shown on the spectrums thus obtained.

Lastly, analyses conducted using the scanning electron microscope revealed (see Figures 1A and 1B) a fairly high degree of compactness, particularly suitable for preventing the diffusion of elements constituting the metallic alloy of the interconnection inside an SOFC.

### FURTHER EXAMPLES

Using procedures analogous to those described previously, further samples of MnₓCo_{y}O_{4-δ} (x+y=3) were prepared with different composition (different values of x and y), in particular with x=1 and y=2.

Equally satisfactory results were obtained, both in terms of compositional purity obtained and in terms of compactness of the coating layer.

## Claims

1. A method for the formation of a protective film comprising a spinel of formula MnₓCo_{y}O_{4-δ}, where x+y=3, on a metallic substrate, **characterized by** comprising the steps of:
a) depositing on the substrate manganese and cobalt as metal species in a molar ratio x/y corresponding to the above formula by thermal co-evaporation; and
b) oxidizing the metal species *in situ* to form the spinel.

2. The method according to claim 1, **characterized in that** said step a) of deposition by way of thermal co-evaporation comprises the steps of:
c) introducing said metallic substrate in a chamber wherein a high vacuum can be created;
d) reducing the pressure within said chamber below 10⁻⁴ mbar;
e) heating said substrate at a temperature comprised in the range from 300°C to 600°C;
f) feeding, from respective evaporation sources, metallic manganese and cobalt in a relative proportion corresponding to that of formula MnₓCo_{y}O_{4-δ}, where x+y=3, so as to deposit a layer of manganese and cobalt as metal species on said substrate obtaining a pre-treated substrate.

3. The method according to claim 1 or 2, **characterized in that** said step b) of *in situ* oxidation of said metal species comprises the step of:
g) bringing the temperature of said pre-treated substrate to a temperature comprised in the range from 500°C to 800°C, while introducing into the chamber, at least in the vicinity of said substrate, a flow of substantially pure gaseous oxygen, until reaching a partial oxygen pressure in the chamber comprised in the range from 500 mbar to 1000 mbar, thus obtaining said protective film on said substrate.

4. The method according to claim 3, **characterized in that** said step b) of *in situ* oxidation comprises the step of maintaining the temperature and pressure conditions reached in said step g) for a time of at least 30 minutes.

5. The method according to any of claims 1 to 4, **characterized in that** said metallic substrate comprises an alloy based on iron and chromium.

6. The method according to claim 5, **characterized in that** said substrate consists of a metal interconnection for SOFC cells.

## Patentansprüche

1. Verfahren zur Bildung eines einen Spinell mit der Formel MnₓCo_{y}O_{4-δ} aufweist, wobei x+y=3, aufweisenden Schutzfilms auf einem metallischen Substrat, **dadurch gekennzeichnet, dass** es die folgenden Schritte aufweist:
a) Aufbringen von Mangan und Kobalt als Metallspezies in einem der genannten Formel entsprechenden Molverhältnis x/y auf das Substrat durch thermische Koevaporation; und
b) Oxidieren der Metallspezies in situ zur Bildung des Spinells.

2. Verfahren nach Anspruch 1, **dadurch gekennzeichnet, dass** der Schritt a) des Aufbringens mittels thermischer Koevaporation die folgenden Schritte aufweist:
c) Einführen des metallischen Substrats in eine Kammer, in welcher ein Hochvakuum erzeugt werden kann;
d) Verringern des Drucks in der Kammer unter 10⁻⁴ mbar;
e) Erwärmen des Substrats bei einer Temperatur im Bereich von 300°C bis 600°C;
f) Zuführen von metallischem Mangan und Kobalt, von jeweiligen Evaporationsquellen, in einem relativen Verhältnis, das der Formel MnₓCo_{y}O_{4-δ} entspricht, wobei x+y=3, um so eine Schicht aus Mangan und Kobalt als Metallspezies auf das Substrat aufzubringen, wodurch ein vorbehandeltes Substrat erhalten wird.

3. Verfahren nach Anspruch 1 oder 2, **dadurch gekennzeichnet, dass** der Schritt b) des In-situ-Oxidierens der Metallspezies den folgenden Schritt aufweist:
g) Bringen der Temperatur des vorbehandelten Substrats auf eine Temperatur im Bereich von 500°C bis 800°C, während in die Kammer, zumindest in der Nähe des Substrats, ein Strom im Wesentlichen reinen gasförmigen Sauerstoffs eingeleitet wird, bis ein Sauerstoffpartialdruck in der Kammer erreicht ist, welcher im Bereich von 500 mbar bis 1000 mbar liegt, wodurch der Schutzfilm auf dem Substrat erhalten wird.

4. Verfahren nach Anspruch 3, **dadurch gekennzeichnet, dass** der Schritt b) des In-situ-Oxidierens den Schritt des Aufrechterhaltens der im Schritt g) genannten Temperatur- und Druckbedingungen für einen Zeitraum von mindestens 30 Minuten aufweist.

5. Verfahren nach einem der Ansprüche 1 bis 4, **dadurch gekennzeichnet, dass** das metallische Substrat eine auf Eisen und Chrom basierende Legierung aufweist.

6. Verfahren nach Anspruch 5, **dadurch gekennzeichnet, dass** das Substrat aus einer metallischen Zwischenverbindung für SOFC-Zellen besteht.

## Revendications

1. Procédé pour la formation d'un film protecteur comprenant un spinelle de formule MnₓCo_{y}O_{4-δ}, où x + y = 3, sur un substrat métallique, **caractérisé en ce qu'**il comprend les étapes de :
a) dépôt, sur le substrat, de manganèse et de cobalt en tant qu'espèces métalliques dans un rapport molaire x/y correspondant à la formule ci-dessus par coévaporation thermique ; et
b) oxydation des espèces métalliques *in situ* pour former le spinelle.

2. Procédé selon la revendication 1, **caractérisé en ce que** ladite étape a) de dépôt par voie de coévaporation thermique comprend les étapes de :
c) introduction dudit substrat métallique dans une chambre dans laquelle un vide poussé peut être créé ;
d) réduction de la pression au sein de ladite chambre en dessous de 10⁻⁴ mbar ;
e) chauffage dudit substrat à une température comprise dans la plage de 300 °C à 600 °C ;
f) apport, à partir de sources d'évaporation respectives, de manganèse et de cobalt métalliques dans une proportion relative correspondant à celle de la formule MnₓCo_{y}O_{4-δ}, où x + y = 3, de façon à déposer une couche de manganèse et de cobalt en tant qu'espèces métalliques sur ledit substrat obtenant un substrat prétraité.

3. Procédé selon la revendication 1 ou 2, **caractérisé en ce que** ladite étape b) d'oxydation *in situ* desdites espèces métalliques comprend l'étape de :
g) amenée de la température dudit substrat prétraité à une température comprise dans la plage de 500 °C à 800 °C, tout en introduisant dans la chambre, au moins à proximité dudit substrat, un flux d'oxygène gazeux sensiblement pur, jusqu'à atteindre une pression partielle d'oxygène dans la chambre comprise dans la plage de 500 mbar à 1 000 mbar, obtenant ainsi ledit film protecteur sur ledit substrat.

4. Procédé selon la revendication 3, **caractérisé en ce que** ladite étape b) d'oxydation *in situ* comprend l'étape de maintien des conditions de température et de pression atteintes à ladite étape g) pendant une durée d'au moins 30 minutes.

5. Procédé selon l'une quelconque des revendications 1 à 4, **caractérisé en ce que** ledit substrat métallique comprend un alliage à base de fer et de chrome.

6. Procédé selon la revendication 5, **caractérisé en ce que** ledit substrat est constitué d'une interconnexion métallique pour des piles SOFC.
